(19) Europäisches Patentamt
European Patent Office
Office européen des brevets

(11) **EP 2 472 274 A2**

(12) **EUROPEAN PATENT APPLICATION**

(43) Date of publication:
**04.07.2012 Bulletin 2012/27**

(51) Int Cl.:
***G01R 31/02*** *(2006.01)*

(21) Application number: **11179122.4**

(22) Date of filing: **29.08.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.12.2010 KR 20100138861**

(71) Applicant: **Elesys Inc.**
**Hyomun-dong, Buk-gu**
**Ulsan (KR)**

(72) Inventor: **Kim, Sang Su**
**Ulsan 682-808 (KR)**

(74) Representative: **Grünecker, Kinkeldey,**
**Stockmair & Schwanhäusser**
**Leopoldstrasse 4**
**80802 München (DE)**

(54) **Apparatus and method for evaluating health of a tap changer**

(57)    Provided are method and apparatus for evaluating health of a tab changer. The method for measuring health of a tab changer mounted in a transformer includes measuring a discharge signal (a first discharge signal) generated in the transformer, separating a discharge signal (a second discharge signal) generated in the tab changer from the first discharge signal, and evaluating the health of the tab changer by comparing the second discharge signal and a first initial value.

**FIG. 1**

**Description**

CROSS-REFERENCE TO RELATED PATENT APPLICATION

This application claims priority from Korean Patent Application No. 10-2010-0138861, filed on December 30, 2010, in the Korean Intellectual Property Office, the disclosure of which is incorporated herein by reference in its entirety.

BACKGROUND

1. Field

Apparatuses and methods consistent with exemplary embodiments relate to evaluating health of a tab changer, and more particularly, to evaluating health of a tab changer provided in a transformer, which can monitor the health of the tab changer based on a degree of abrasion at a contact point of the tab changer.

2. Description of the Related Art

In a general transformer, a reduced voltage is applied to a primary side of the transformer due to a loss of transmitted or distributed electric power, and accordingly, an output secondary voltage is also less than a rated voltage. Therefore, the voltage becomes unstable due to a load variation and a load loss.

In order to solve these problems, the transformer uses a no load tap changer (NLTC) or an on load tap changer (OLTC). The NLTC adjusts a tap in a state in which a load does not exist, i.e., in a power-off state, whereas the OLTC adjusts a tap manually or automatically in a state in which a load exists. The NLTC or the OLTC levels a primary voltage up or down to a rated voltage by adjusting the tap so that an output voltage of the transformer can be maintained constantly.

The NLTC should turn off the power to adjust the tab of the transformer and thus it is limited to specific purposes such as installation or maintenance of the transformer. On the other hand, the OLTC has a complicated structure, is expensive and has a great size compared to the general NLTC. Therefore, the OLTC is employed in an electric power transformer (or a transformer for electric power transmission). However, when the tab is switched using the OLTC, a contact point of a switch in the OLTC suffers abrasion according to a load of the transformer. If a degree of abrasion exceeds a reference load factor, damage to the OLTC becomes more serious and may cause an accident such as a blackout. Therefore, there is a demand for a method for exactly evaluating a degree of abrasion of an OLTC and avoiding damage or loss of a transformer.

SUMMARY

One or more aspects of the exemplary embodiments provide an apparatus and a method for evaluating health of a tab changer, which can exactly calculate a degree of abrasion at a contact point of the tab changer based on a discharge signal and monitor health of the tab changer.

According to an aspect of an exemplary embodiment, there is provided a method for evaluating health of a tab changer mounted in a transformer, the method including: measuring a discharge signal (a first discharge signal) generated in the transformer, separating a discharge signal (a second discharge signal) generated in the tab changer from the first discharge signal, and evaluating the health of the tab changer by comparing the second discharge signal and a first initial value.

According to an aspect of another exemplary embodiment, there is provided an apparatus for evaluating health of a tab changer mounted in a transformer, the apparatus including: a sensor which measures a discharge signal (a first discharge signal) generated in the transformer, and a health evaluation unit which separates a discharge signal (a second discharge signal) generated in the tab changer from the measured first discharge signal, and compares the second discharge signal and a first initial value, thereby evaluating the health of the tab changer.

According to an aspect of still another exemplary embodiment, there is provided a computer readable recording medium which records a program that executes at least one of the methods described above in a computer.

BRIEF DESCRIPTION OF THE DRAWINGS

The above and other features and advantages will become more apparent by describing in detail exemplary embodiments with reference to the attached drawings in which:

FIG. 1 is a view illustrating a system for evaluating health of a tab changer according to an exemplary embodiment;

FIG. 2 is a block diagram illustrating a health evaluating apparatus according to an exemplary embodiment;

FIG. 3A is a view illustrating an example of a first initial value;

FIG. 3B is a view illustrating an example of a second initial value;

FIG. 4 is a view illustrating an example of a first discharge signal;

FIG. 5 is a view to explain a process of a discharge signal separation unit separating a second discharge signal from a first discharge signal using a third discharge signal;

FIG. 6 is a flowchart illustrating a method for evaluating health of a tab changer according to an exemplary embodiment; and

FIG. 7 is a flowchart to explain operations S640 and S650 of FIG. 6 in detail.

DETAILED DESCRIPTION OF EXEMPLARY EMBODIMENTS

Exemplary embodiments will now be described more fully with reference to the accompanying drawings to clarify aspects, features and advantages. Exemplary embodiments may, however, be embodied in many different forms and should not be construed as limited to the exemplary embodiments set forth herein. Rather, these exemplary embodiments are provided so that this disclosure will be thorough and complete, and will fully convey the scope of the inventive concept to those of ordinary skill in the art. It will be understood that when an element, layer or region is referred to as being "on" another element, layer or region, the element, layer or region can be directly on another element, layer or region or intervening elements, layers or regions.

The terms used herein are for the purpose of describing particular embodiments only and are not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, layers, regions, elements, components, and/or groups thereof, but do not preclude the presence or addition of one or more other features, integers, steps, operations, layers, regions, elements, components, and/or groups thereof. As used herein, the term "and/or" includes any and all combinations of one or more of the associated listed items. Furthermore, expressions such as "at least one of," when preceding a list of elements, modify the entire list of elements and do not modify the individual elements of the list.

As the inventive concept allows for various changes and numerous embodiments, particular exemplary embodiments will be illustrated in the drawings and described in detail in the written description. However, this is not intended to limit the present inventive concept to particular modes of practice, and it is to be appreciated that all changes, equivalents, and substitutes that do not depart from the spirit and technical scope of the present inventive concept are encompassed in the present inventive concept. In the description of the exemplary embodiment, certain detailed explanations of related art are omitted when it is deemed that they may unnecessarily obscure the essence of the inventive concept.

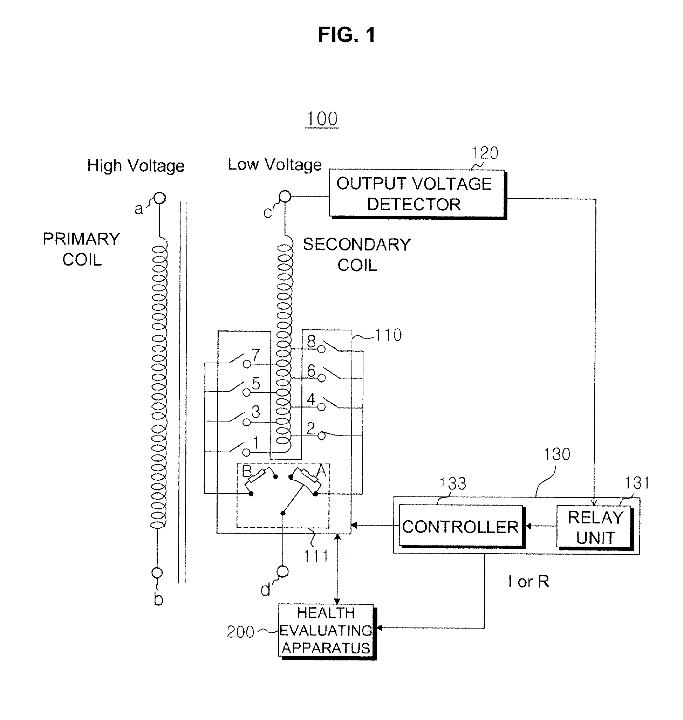

FIG. 1 is a view illustrating a system for evaluating health of a tab changer according to an exemplary embodiment.

Referring to FIG. 1, the system for evaluating the health of the tab changer includes a transformer 100 and a health evaluating apparatus 200.

The transformer 100 is an electric power transformer and can level a transmission voltage up or down to a voltage desirable for a house or an electric power customer. The transformer 100 may include a tab changer 110, an output voltage detector 120, and a tab changer controller 130. In general, the transformer 100 may be physically divided into a tab changer tank and a main tank. The tab changer 110 may correspond to the tab changer tank, and a block comprising a primary coil, a secondary coil, the output voltage detector 120, and the tab changer controller 130 to convert a voltage may correspond to the main tank. The tab changer tank and the main tank may be divided by a partition.

The tab changer 110 is mounted in the transformer 100 to adjust an output voltage of the transformer 100 and may be an on load tap changer (OLTC). The tab changer 110 adjusts the output voltage of the secondary coil by performing tab switching automatically in response to a variation of a voltage applied to the primary coil, so that the output voltage of the secondary coil is maintained within an output voltage error range. The output voltage error range may be 1% to 10% of an applied voltage, for example. To achieve this, the tab changer 110 may be electrically connected to the secondary coil. The output voltage varies according to the voltage applied to the primary coil. In the present exemplary embodiment, the tab changer 110 is disposed adjacent to the secondary coil. However, this is merely an example and the tab changer 110 may be disposed adjacent to the primary coil.

The primary coil is connected to a line terminal 'a' and a neutral terminal 'b' and a high voltage is applied to the line terminal 'a'. The secondary coil is connected to a line terminal 'c' and a neutral terminal 'd' and a low voltage is output from the line terminal 'c'.

The tab changer 110 may include a plurality of tabs 1~8 and a tab switching unit 111. If the tab switching unit 111 is switched from 'A' to 'B', at least one of tabs 1, 3, 5, 7 applies an electric current, thereby outputting a voltage. In FIG. 1, the tabs 1 to 8 are depicted in the shape of a switch, but it means that the tabs work by means of electricity. In practice, the tabs may be realized by an electric power element capable of outputting a voltage or an output lead bar physically contacting an electric power element.

The output voltage detector 120 detects the output voltage output from the secondary coil after a voltage is applied to the primary coil, and outputs the output voltage to the tab changer controller 130.

The tab changer controller 130 may control a tab switching operation of the tab changer 110 using the output voltage output from the output voltage detector 120. To achieve this, the tab changer controller 130 may include a relay unit 131 and a controller 133.

The relay unit 131 converts the output voltage output from the output voltage detector 120 into an electric current or a resistance value, and outputs the converted electric current or resistance value to the controller 133 and the health evaluating apparatus 200.

The controller 133 compares the applied voltage of the transformer 100, i.e., the voltage applied to the primary coil, and the output voltage from the output voltage detector 120, and controls the tab switching of the tab changer 110 so that the output voltage is maintained within the output voltage error range. For example, if the output voltage detected when the tab 1 is in an on-state is out of the output voltage error range, the controller 133 may control the tab switching unit 111 to switch the tab of the tab changer 110 from the tab 1 to a different suitable tab.

The health evaluating apparatus 200 evaluates health of the tab changer 110 which is used to adjust the output voltage of the transformer 100. If the tab switching unit 111 switches the tabs, a degree of abrasion at contact points of the tabs 1 to 8 changes according to an amount of load of the transformer 100. Therefore, the health evaluating apparatus 200 calculates the degree of abrasion at the contact points of the tabs 1 to 8 based on a discharge signal of the transformer 100 on a real time basis, and evaluates health of each of the tabs 1 to 8. This is to prevent damage to the tab changer 110 or an accident such as a blackout, which may occur as the degree of abrasion at the contact points exceeds a specific load factor.

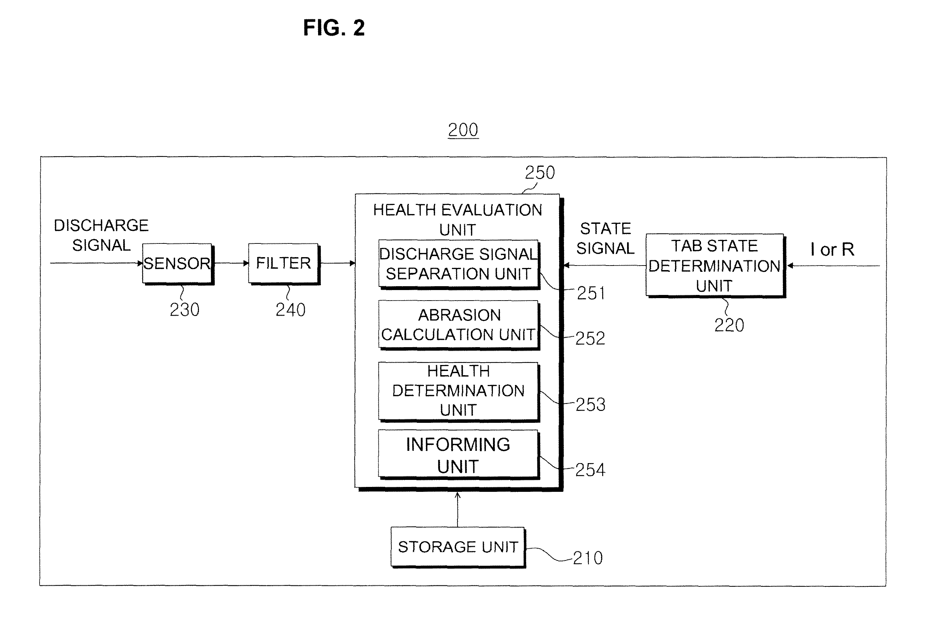

FIG. 2 is a block diagram illustrating a health evaluating apparatus according to an exemplary embodiment.

Referring to FIG. 2, the health evaluating apparatus 200 according to an exemplary embodiment includes a storage unit 210, a tab state determination unit 220, a sensor 230, a filter 240, and a health evaluation unit 250.

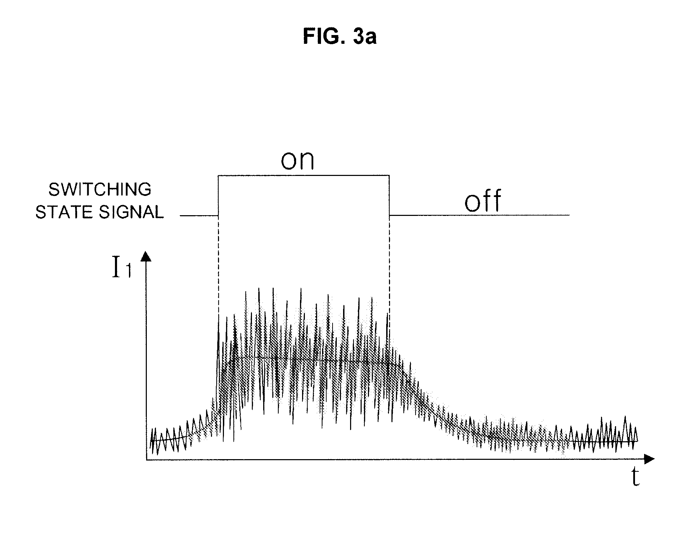

The storage unit 210 may store a first initial value $I_1$ and a second initial value $I_2$ that the health evaluating apparatus 200 uses to determine a degree of abrasion of each of the tabs 1 to 8. The first initial value $I_1$ is a discharge signal that is generated in the tab changer 110 and is initially measured when a switching state of the tab changer 110 is 'on' after the transformer 100 has been installed. The first initial value $I_1$ may have a form shown in FIG. 3A. If the switching state of the tab changer 110 is 'off', the discharge signal is rarely generated in the tab changer 110. As a time elapses, the discharge signal which is generated when the switching state of the tab changer 110 is 'on' has a form similar to that of the first initial value $I_1$ but its amplitude may be changeable.

The second initial value $I_2$ is a discharge signal that is generated in the transformer 100 and is initially measured when the switching state of the tab changer 110 is 'off' after the transformer 100 has been installed. If input electric power uses a frequency of 60Hz, a frequency of 120Hz is output during a first period ($t_1$). Also, if the input electric power uses a frequency of 50Hz, a frequency of 100Hz is output during the first period ($t_1$). The second initial value $I_2$ may be used as an example of a third discharge signal, which will be described below.

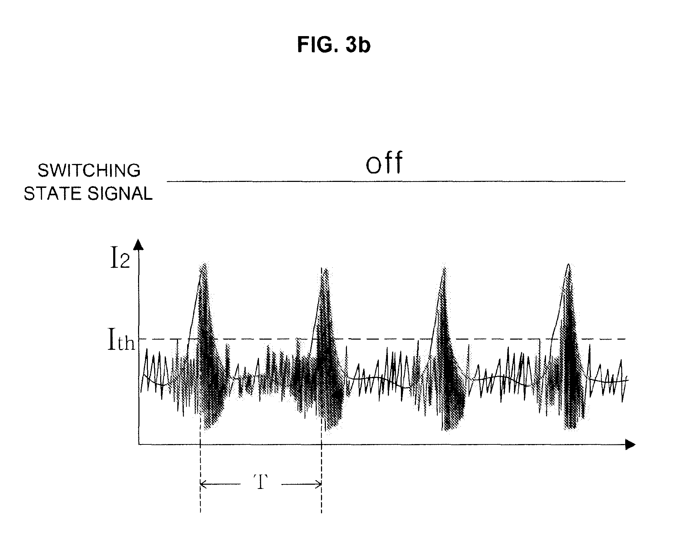

In practice, the second initial value $I_2$ is a discharge signal that is initially generated in the main tank of the transformer 100. However, an initial discharge signal generated in the transformer 100 is referred to as the second initial value $I_2$ for convenience of explanation. Accordingly, the second initial value $I_2$ does not include a discharge signal that is generated in the tab changer 110, as shown in FIG. 3B.

Also, the storage unit 210 accumulatively stores results of determining health of the tabs 1 to 8 by the tab changer 110. The result of determining the health indicates the degree of abrasion of each of the tabs 1 to 8 determined by a health determination unit 253, and may be stored along with a time at which the health is evaluated and discharge signals used for evaluating the health.

The tab state determination unit 220 obtains a determination signal to determine whether the tab changer 110 is switched or not and determines whether the tab changer 100 is switched or not based on the determination signal. The tab changer 110 is switched if a tab to apply an electric current is changed. The determination signal may be a current I or a resistance R input from the relay unit 131. In other words, the tab state determination unit 220 determines whether the tab changer 110 is switched or not based on the current I or the resistance R input from the relay unit 131. It is determined that the tab changer 110 is switched (i.e., that the switching state is 'on'), if the tab switching unit 111 is switched from position 'A' to position 'B'. Also, it is determined that the tab changer 110 is not switched (i.e., that the switching stat is 'off'), if the tab switching unit 111 is in position 'A' or 'B'.

For example, if the input determination signal is the current I and 17 tabs are installed in the tab changer 110, the current I may have a value between 0 and 20mA. If the input current I is 0, the tab state determination unit 220 determines that the first tab is switched, and, if a current of about 1.176mA is input, the tab state determination unit 220 determines that the second tab is switched. If a current of 20mA is input, the tab state determination unit 220 determines that the 17th tab is switched.

If the input determination signal is the resistance R and 17 tabs are installed in the tab changer 110, the resistance R may have a value between 0 and 1600hm. If the input resistance R is 0, the tab state determination unit 220 determines that the first tab is switched, and, if a resistance of about 100hm is input, the tab state determination unit 220 determines that the second tab is switched. If a resistance of 160 Ohm is input, the tab state determination unit 220 determines that the 17th tab is switched.

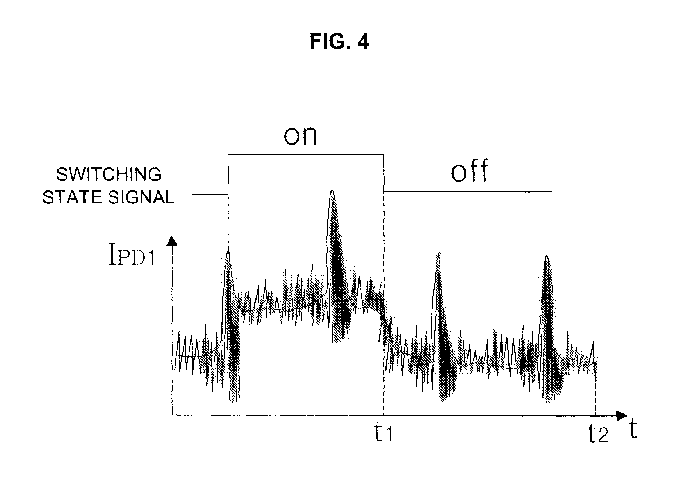

The sensor 230 measures a discharge signal (hereinafter, referred to as a first discharge signal $I_{PD1}$) generated in the transformer 100. Since the tab changer 110 performs tab switching periodically or aperiodically, the first discharge signal $I_{PD1}$ is changed according to whether the switching state is 'on' or 'off' as shown in FIG. 4. Referring to FIG. 4, if the switching state of the tab changer 110 is 'on', the first discharge signal $I_{PD1}$ is a mixture signal in which a discharge signal generated in the tab changer 110 and a discharge signal generated in the transformer 100 are mixed. If the switching state is 'off', the first discharge signal $I_{PD1}$ is a discharge signal generated in the transformer 100.

For example, the sensor 230 may use a high frequency current transformer (HFCT), which measures a high frequency current flowing in a grounded line of the tab changer 110 or the transformer 100 as the first discharge signal ($I_{PD1}$).

The filter 240 filters a signal of a specific frequency band from the first discharge signal $I_{PD1}$ output from the sensor 230, thereby removing signals except for the signal of the specific frequency band. The filter 240 may be a band pass filter.

The health evaluation unit 250 separates a discharge signal (hereinafter, referred to as a second discharge signal $I_{PD2}$) generated in the tab changer 110 from the first discharge signal $I_{PD1}$ output from the sensor 230 or the filter 240, and compares the second discharge signal $I_{PD2}$ and the pre-stored first initial value $I_1$, thereby evaluating the health of the tab changer 110.

To achieve this, the health evaluation unit 250 may include a discharge signal separation unit 251, an abrasion calculation unit 252, a health determination unit 253, and an informing unit 254.

The discharge signal separation unit 251 separates the second discharge signal $I_{PD2}$ from the first discharge signal $I_{PD1}$ using a transformer discharge signal (hereinafter, referred to as a third discharge signal $I_{PD3}$) measured if the tab changer 110 is not switched. If the tab state determination unit 220 determines that the tab changer 110 is switched, the discharge signal separation unit 251 separates the second discharge signal $I_{PD2}$ while the tab changer 110 is switched. Information on a time during which the tab changer 110 is switched may be provided from a controller 233, and the discharge signal separation unit 251 may separate the second discharge signal $I_{PD2}$ corresponding to the time.

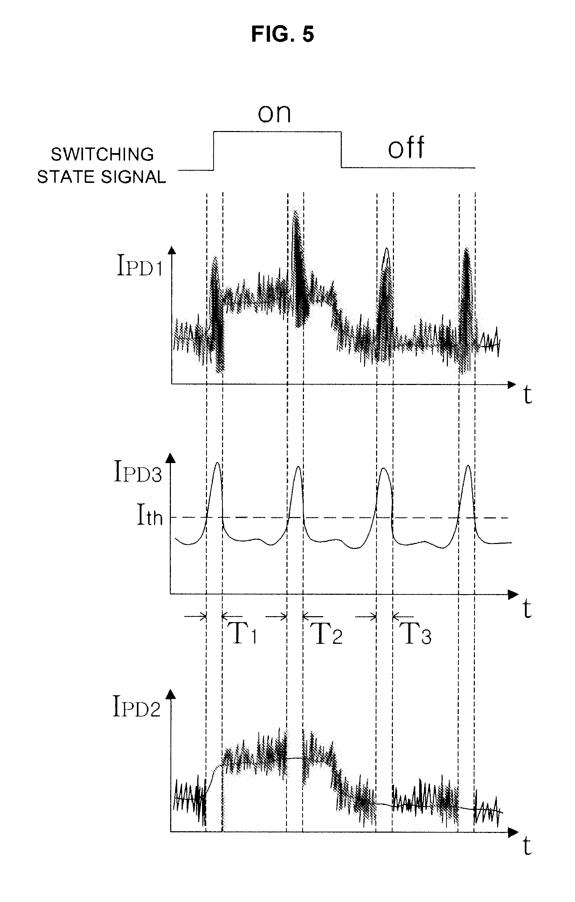

FIG. 5 is a view to explain a process of the discharge signal separation unit 251 separating the second discharge signal $I_{PD2}$ from the first discharge signal $I_{PD1}$ using the third discharge signal $I_{PD3}$.

Referring to FIG. 5, the discharge signal separation unit 251 may separate the second discharge signal $I_{PD2}$ by converting a signal of a specific time band ($T_n$, n=1, 2, 3...) of the first discharge signal $I_{PD1}$ into a zero level. The specific time band $T_n$ is a time band in which the third discharge signal $I_{PD3}$ is greater than or equal to a threshold value $I_{th}$, and for example, is denoted by T1, T2, T3 in FIG. 5. Also, the threshold value $I_{th}$ may be set by a user or an administrator.

Referring to the third drawing of FIG. 5, a waveform signal indicates the third discharge signal $I_{PD3}$ and a sold line, which is a trend line, is derived using a mathematical tool such as a Rhind Mathematical Papyrus (RMP). For example, in comparing the third discharge signal $I_{PD3}$ and the first initial value to calculate the degree of abrasion, the trend lines may be compared. However, this is merely an example and the waveform signals may be compared without using the trend lines to calculate the degree of abrasion.

The third discharge signal $I_{PD3}$ used for separating the second discharge signal $I_{PD2}$ may be any one of the following four signals:

1. The third discharge signal $I_{PD3}$ may be the second initial value described above with reference to FIG. 3B;

2. The third discharge signal $I_{PD3}$ may be a discharge signal of the first discharge signal $I_{PD1}$ described above with reference to FIG. 4, which is generated in the transformer 100 in the off-switching state of the tab changer 110 (hereinafter, referred to as a fourth discharge signal $I_{PD4}$). In other words, the third discharge signal $I_{PD3}$ of this case is a signal measured along with the first discharge signal $I_{PD1}$ on a real time basis and may be a signal measured during the time $t_1$ to $t_2$ in FIG. 4.

3. The third discharge signal $I_{PD3}$ may be a discharge signal that is generated in the transformer 100 in the off-switching state of the tab changer 110 before the first discharge signal $I_{PD1}$ is measured. In this case, the discharge signal generated in the transformer 100 in the off-switching state of the tab changer 110 is updated and stored in the storage unit 210. The discharge signal most recently updated may be used for separating the second discharge signal $I_{PD2}$. For example, if the first discharge signal $I_{PD1}$ is measured after the second initial value $I_2$ has been measured, the discharge signal separation unit 251 uses the second initial value $I_2$ as the third discharge signal $I_{PD3}$, updates the second initial value $I_2$ to the fourth discharge signal $I_{PD4}$ included in the first discharge signal $I_{PD1}$, and uses the fourth discharge signal $I_{PD4}$ as the third discharge signal $I_{PD3}$.

4. The third discharge signal $I_{PD3}$ may be one of the pre-stored second initial value $I_2$ and the fourth discharge signal $I_{PD4}$ that has a greater value. The second initial value $I_2$ and the fourth discharge signal $I_{PD4}$ may be compared by the discharge signal separation unit 251. If the second initial value $I_2$ is greater than the fourth discharge signal $I_{PD4}$, the discharge signal separation unit 251 may substitute the second initial value $I_2$ with the fourth discharge signal $I_{PD4}$. In other words, the storage unit 210 may update the second initial value $I_2$ to the fourth discharge signal $I_{PD4}$.

The abrasion calculation unit 252 compares the second discharge signal $I_{PD2}$ separated by the discharge signal separation unit 251 and the pre-stored first initial value $I_1$, and, if the second discharge signal $I_{PD2}$ is greater than the first initial value $I_1$, the abrasion calculation unit 252 calculates a degree of abrasion of a corresponding tab. This is because the fact that the second discharge signal $I_{PD2}$ is greater than the first initial value $I_1$ means that the discharge signal generated in the tab changer 110 exceeds a reference value and thus a serious degree of abrasion occurs.

The abrasion calculation unit 252 may calculate a degree of abrasion at a contact point of a tab using following equation 1:

[Equation 1]

$$tab_n = \frac{I_{PD2}}{I_1}$$

Referring to equation 1, $tab_n$ refers to an nth tab (n=1, 2,...8) and a degree of abrasion at a contact point of the nth tab is expressed by a ratio of the second discharge signal $I_{PD2}$ generated at the nth tab (e.g., a maximum value of the waveform signal or a maximum value of the trend line) to the first initial value $I_1$ (e.g., a maximum value of the waveform signal or a maximum value of the trend line). To achieve this, the abrasion calculation unit 252 applies a reduced multivariate polynomial (RMP) model to the separated second discharge signal $I_{PD2}$ and the first initial value $I_1$, thereby deriving a trend line of the second discharge signal $I_{PD2}$ and a trend line of the first initial value $I_1$. The abrasion calculation unit 252 calculates a ratio of the trend line of the second discharge signal $I_{PD2}$ to the trend line of the first initial value $I_1$ as the degree of abrasion at the contact point of the tab.

Equation 1 used for calculating the degree of abrasion at the contact point is merely an example and the calculating of the degree of abrasion is not limited to equation 1.

The health determination unit 253 determines health of the tab changer 110 or health of the corresponding tab based on the calculated degree of abrasion. For example, if the degree of abrasion is greater than a preset reference value, the health determination unit 253 determines that the degree of abrasion at the contact point is serious.

The informing unit 254 may inform the user or administrator of at least one of the degree of abrasion at the contact point and the health of the tab changer 110. The informing unit 254 informs in various ways such as using a short message service (SMS) or emailing.

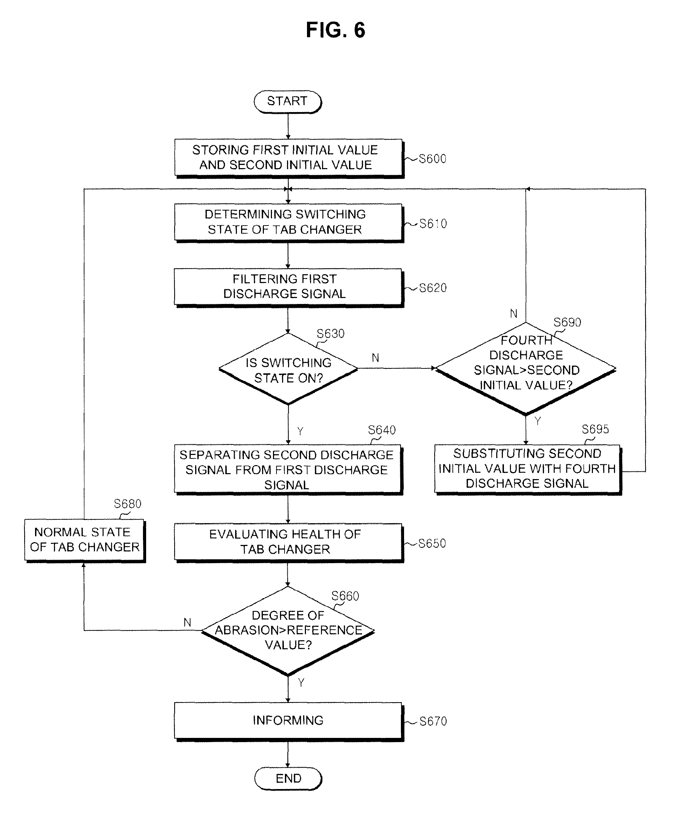

FIG. 6 is a flowchart illustrating a method for evaluating health of a tab changer according to an exemplary embodiment.

An apparatus performing the method for evaluating the health of the tab changer of FIG. 6 may be the health evaluating apparatus 200 described above with reference to FIGS. 1 and 2 or a health evaluating processor.

In operation S600, the apparatus measures and stores a first initial value and a second initial value, if a transformer is installed. The first initial value is a discharge signal that is generated in the tab changer and initially measured in an on-switching state of the tab changer after the transformer has been installed, and may have a form as shown in FIG. 3A. The second initial value is a discharge signal that is generated in the transformer and initially measured in an off-switching state of the tab changer after the transformer has been installed, and may have a form as shown in FIG. 3B

In operation S610, the apparatus determines whether the tab changer is switched or not. The apparatus may determine whether the tab changer is switched or not using a current or a resistance converted from an output voltage of the transformer. Hereinafter, if the tab changer is switched, the switching state of tab changer is 'on', and if the tab changer is not switched, the switching state of the tab changer is 'off'.

In operation S620, the apparatus may filter a first discharge signal which is measured by a sensor such as a high frequency current transformer (HFCT). The first discharge signal may be a mixture signal in which a discharge signal generated in the tab changer in the on-switching state of the tab changer is mixed with a discharge signal generated in the transformer, and may have a form as shown in FIG. 4.

If it is determined that the switching state of the tab changer is 'on' in operation S630, the apparatus separates a second discharge signal from the first discharge signal in operation S640. The separated second discharge signal may have a form as shown in FIG. 5.

In operation S650, the apparatus compares the second discharge signal and the first initial value, thereby evaluating health of the tab changer.

In operation S660, the apparatus compares a degree of abrasion at a contact point which is calculated in operation S650 (i.e., health of a corresponding tab of the tab changer) and a reference value.

If the degree of abrasion is greater than the reference value (S660-Y), the apparatus informs an administrator of the transformer that the degree of abrasion is serious.

On the other hand, if the degree of abrasion is less than the reference value (S660-N), the apparatus determines that the tab changer of the transformer is in a normal state and returns to operation S610.

On other hand, if it is determined that the switching state of the tab changer is 'off' (S630-N), in operation S680, the apparatus compares a fourth discharge signal and the second initial value in operation S690. The fourth discharge signal may be a discharge signal of the first discharge signal that is generated in the transformer in the off-switching state of the tab changer and may be a signal that is measured during the time $t_1$ to $t_2$ of FIG. 4.

If the fourth discharge signal is greater than the second initial value (S690-Y), the apparatus may store the fourth discharge signal instead of the second initial value stored in operation 600.

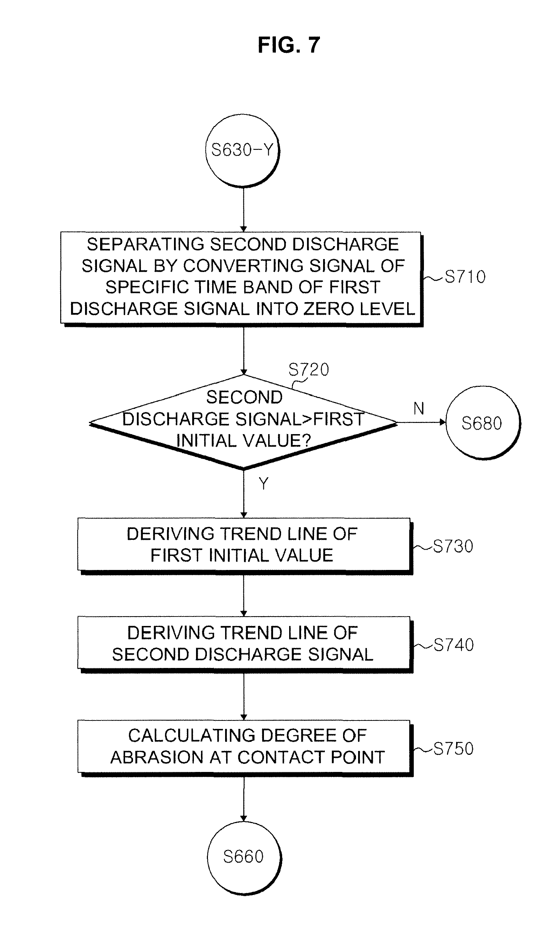

FIG. 7 is a flowchart illustrating operations S640 and S650 of FIG. 6 in detail.

In operation S710, the apparatus separates the second discharge signal from the first discharge signal by converting a signal of the first discharge signal that corresponds to a specific time band into a zero level. The specific time band is a time band in which the third discharge signal is greater than or equal to a threshold value.

In operation S720, the apparatus compares the second discharge signal and the first initial value.

If the second discharge signal is greater than the first initial value (S720-Y), the apparatus drives a trend line of the first initial value using an RMP model in operation S730. The apparatus derives a trend line of the second discharge signal in operation S740.

In operation S750, the apparatus calculates a degree of abrasion at a contact point of the tab changer (or a corresponding tab having generated the first discharge signal) based on a ratio of the second discharge signal to the first initial value.

In the above-described exemplary embodiments, the configuration of the transformer shown in FIG. 1 is merely an example and the present disclosure is not limited to the configuration of the transformer of FIG. 1. For example, 8 tabs are provided in FIG. 1, but other number of tabs may be provided. Also, the tab changer 110 is installed adjacent to the secondary coil. However, this is merely an example and the tab changer 110 may be installed adjacent to the primary coil.

In the exemplary embodiment of FIG. 2, the sensor 230 is included in the health evaluating apparatus 200. However, the sensor 230 may be provided separately from the health evaluating apparatus 200. A result of sensing by the sensor 230 may be transmitted to the health evaluating apparatus 200 in a wired or wireless manner. Also, the health evaluating apparatus 200 includes the filter 240 in the above exemplary embodiment, but may not include the filter 240 in some situation.

In the exemplary embodiment of FIG. 2, the health evaluation unit 250 may be realized in the form of hardware and/or software, and the signals illustrated in FIGS. 3 to 5 are merely an example and may have different forms.

According to the exemplary embodiments, the degree of abrasion at the contact point of the tab changer provided in the transformer can be calculated based on the discharge signal that is generated according to the switching state of the tab changer, and the health of the tab changer can be monitored based on the degree of abrasion. Also, as the degree of abrasion or the health is accumulatively stored for every tab, the health of the tab changer can be continuously checked. Also, an abnormal condition is detected in early stages so that the transformer can stably work and an accident such as a blackout can be prevented beforehand.

While exemplary embodiments have been particularly shown and described above, it will be understood by those of ordinary skill in the art that various changes in form and details may be made therein without departing from the spirit and scope of the present invention as defined by the following claims.

**Claims**

1. A method for evaluating health of a tab changer mounted in a transformer, the method comprising:

   measuring a discharge signal (a first discharge signal) generated in the transformer;
   separating a discharge signal (a second discharge signal) generated in the tab changer from the first discharge signal; and
   evaluating the health of the tab changer by comparing the second discharge signal and a first initial value.

2. The method as claimed in claim 1, wherein the measuring of the first discharge signal comprises measuring the first discharge signal using a high frequency current transformer (HFCT).

3. The method as claimed in claim 1, wherein the separating of the second discharge signal comprises separating the second discharge signal from the first discharge signal using a discharge signal (a third discharge signal) of the transformer that is generated if the tab changer is in an off-switching state.

4. The method as claimed in claim 2, wherein the separating of the second discharge signal comprises converting a signal of a specific time band of the first discharge signal into a zero level,
   wherein the specific time band is a time band in which the third discharge signal is greater than or equal to a threshold value.

5. The method as claimed in claim 4, wherein the third discharge signal is a second initial value or a part of the first discharge signal that is generated in the transformer in an off-switching state of the tab changer,
   wherein the second initial value is a discharge signal that is initially generated and measured in the transformer in the off-switching state of the tab changer.

6. The method as claimed in claim 4, wherein the third discharge signal is one of a second initial value and a fourth discharge signal that has a greater value, the fourth discharge signal being a part of the first discharge signal that is generated in the transformer in an off-switching state of the tab changer.

7. The method as claimed in claim 6, further comprising, if the fourth discharge signal is greater than the second initial value, substituting the second initial value with the fourth discharge signal.

8. The method as claimed in claim 1, further comprising obtaining a determination signal to determine whether the tab changer is switched or not, wherein the separating of the second discharge signal comprises separating the second discharge signal based on the determination signal while the tab changer is switched.

9. The method as claimed in claim 1, further comprising:

   accumulatively storing results of evaluating the health of the tab changer; and filtering a signal of a specific frequency band from the first discharge signal, wherein the separating the second discharge signal comprises separating the second discharge signal from the filtered signal.

10. The method as claimed in claim 1, wherein the evaluating the health of the tab changer comprises:

   comparing the second discharge signal and the first initial value and calculating a degree of abrasion if the second discharge signal is greater than the first initial value; determining the heath of the tab changer based on the calculated degree of abrasion; and informing a user of at least one of the degree of abrasion and the health of the tab changer.

11. An apparatus for evaluating health of a tab changer mounted in a transformer, the apparatus comprising:

   a sensor which measures a discharge signal (a first discharge signal) generated in the transformer; and a health evaluation unit which separates a discharge signal (a second discharge signal) generated in the tab changer from the measured first discharge signal, and compares the second discharge signal and a first initial value, thereby evaluating the health of the tab changer.

12. The apparatus as claimed in claim 11, wherein the health evaluation unit comprises a discharge signal separation unit which separates the second discharge signal from the first discharge signal using a discharge signal (a third discharge signal) which is generated in the transformer if the tab changer is in an off-switching state.

13. The apparatus as claimed in claim 12, wherein the discharge signal separation unit converts a signal of a specific time band of the first discharge signal into a zero level and separates the second discharge signal by removing the third discharge signal in which the signal of the specific time band is converted into the zero level from the first discharge signal, wherein the specific time band is a time band in which the third discharge signal is greater than or equal to a threshold value.

14. The apparatus as claimed in claim 13, wherein the third discharge signal is a second initial value or a part of the first discharge signal that is generated in the transformer in an off-switching state of the tab changer, wherein the second initial value is a discharge signal that is initially generated and measured in the transformer in the non-switching state of the tab changer.

15. The apparatus as claimed in claim 13, wherein the third discharge signal is one of a second initial value and a fourth discharge signal that has a greater value, the fourth discharge signal being a part of the first discharge signal that is generated in the transformer in an off-switching state of the tab changer.

16. The apparatus as claimed in claim 15, wherein, if the fourth discharge signal is greater than the second initial value, the discharge signal separation unit substitute the second initial value with the fourth discharge signal.

17. The apparatus as claimed in claim 13, wherein the discharge signal separation unit separates the second discharge signal based on a determination signal while the tab changer is switched, the determining signal being a signal that determines whether the tab changer is switched or not.

18. The apparatus as claimed in claim 13, further comprising:

   a storage unit which accumulatively stores results of determining the health of the tab changer; and a filter which filters a signal of a specific frequency band from the first discharge signal, wherein the storage unit stores results of determining health of every tab of the tab changer, wherein the health evaluation unit separates the second discharge signal from the filtered first discharge signal.

19. The apparatus as claimed in claim 13, wherein the health evaluation unit comprises:

   an abrasion calculation unit which calculates a degree of abrasion if the second discharge signal is greater than the first initial value;

a health determination unit which determines health of the tab changer based on the calculated degree of abrasion; and

an informing unit which informs a user of at least one of the calculated degree of abrasion and the health of the tab changer.

20. A computer readable recording medium which records a program that executes the method of claim 8 in a computer.

FIG. 1

100

High Voltage    Low Voltage

OUTPUT VOLTAGE
DETECTOR

120

a

PRIMARY
COIL

c

SECONDARY
COIL

110

7    8
5    6
3    4
1    2

B    A

130

133    131

CONTROLLER ← RELAY
UNIT

111

d

I or R

200 — HEALTH
EVALUATING
APPARATUS

b

**FIG. 2**

EP 2 472 274 A2

**FIG. 3a**

**FIG. 3b**

SWITCHING STATE SIGNAL — off

I2

Ith

T

## FIG. 4

## FIG. 5

# FIG. 6

START

STORING FIRST INITIAL VALUE
AND SECOND INITIAL VALUE — S600

DETERMINING SWITCHING
STATE OF TAB CHANGER — S610

FILTERING FIRST
DISCHARGE SIGNAL — S620

S630
IS SWITCHING
STATE ON? — N →

N     S690
FOURTH
DISCHARGE
SIGNAL>SECOND
INITIAL VALUE?

Y     S640

SEPARATING SECOND DISCHARGE
SIGNAL FROM FIRST DISCHARGE
SIGNAL

Y     S695
SUBSTITUTING SECOND
INITIAL VALUE WITH FOURTH
DISCHARGE SIGNAL

S680
NORMAL STATE
OF TAB CHANGER

EVALUATING HEALTH OF
TAB CHANGER — S650

S660
DEGREE OF
N — ABRASION>REFERENCE
VALUE?

Y

INFORMING — S670

END

## FIG. 7

S630-Y

SEPARATING SECOND DISCHARGE SIGNAL BY CONVERTING SIGNAL OF SPECIFIC TIME BAND OF FIRST DISCHARGE SIGNAL INTO ZERO LEVEL — S710

SECOND DISCHARGE SIGNAL>FIRST INITIAL VALUE? — S720

N → S680

Y

DERIVING TREND LINE OF FIRST INITIAL VALUE — S730

DERIVING TREND LINE OF SECOND DISCHARGE SIGNAL — S740

CALCULATING DEGREE OF ABRASION AT CONTACT POINT — S750

S660

**EP 2 472 274 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020100138861